(19) **Europäisches Patentamt**

**European Patent Office**

**Office européen des brevets**

(11) **EP 0 938 186 B1**

(12) **EUROPEAN PATENT SPECIFICATION**

(45) Date of publication and mention
of the grant of the patent:
**12.11.2003 Bulletin 2003/46**

(51) Int Cl.⁷: **H03F 3/00**, H03F 3/72

(21) Application number: **98830077.8**

(22) Date of filing: **19.02.1998**

(54) **Switching of a capacitor on a mutually exclusive selected one of a plurality of integrated amplifiers**

Anschliessen einer Kapazität an einen gegenseitig exklusiv selektierten integrierten Verstärker aus einer Vielzahl von integrierten Verstärkern

Connexion d'une capacité à un amplificateur intégré choisi mutuellement exclusif parmi plusieurs

(84) Designated Contracting States:
**DE FR GB IT**

(43) Date of publication of application:
**25.08.1999 Bulletin 1999/34**

(73) Proprietor: **STMicroelectronics S.r.l.**
**20041 Agrate Brianza (Milano) (IT)**

(72) Inventors:
 • **Cali', Giovanni**
 **95100 Catania (IT)**
 • **Granata, Angelo**
 **96100 Siracusa (IT)**
 • **Palmisano, Giuseppe**
 **95100 Catania (IT)**

(74) Representative: **Pellegri, Alberto et al**
 **c/o Società Italiana Brevetti S.p.A.**
 **Piazza Repubblica, 5**
 **21100 Varese (IT)**

(56) References cited:
 **EP-A- 0 695 106**     **US-A- 3 798 468**
 **US-A- 5 148 121**     **US-A- 5 608 348**

**Description**

The present invention relates in general to integrated circuits and in particular to systems of selection among alternative electric paths of functional circuits in order to modify the electrical parameters of the functional circuit adapting it to the conditions of operation of the integrated system.

In many applications, particularly but not exclusively, of circuits operating at the radio frequency (RF) or generally operating at a relatively high frequency, it is often necessary to replicate several times the same circuit or functional block, each designed with certain electric characteristics in order to optimize its performance in a limited range of signal frequencies.

The circuit or functional block that is more adequate to the current conditions of operation is then automatically selectable by closing and opening switches and/or commanding path selectors that choose one among several available paths.

BACKGROUND OF THE INVENTION

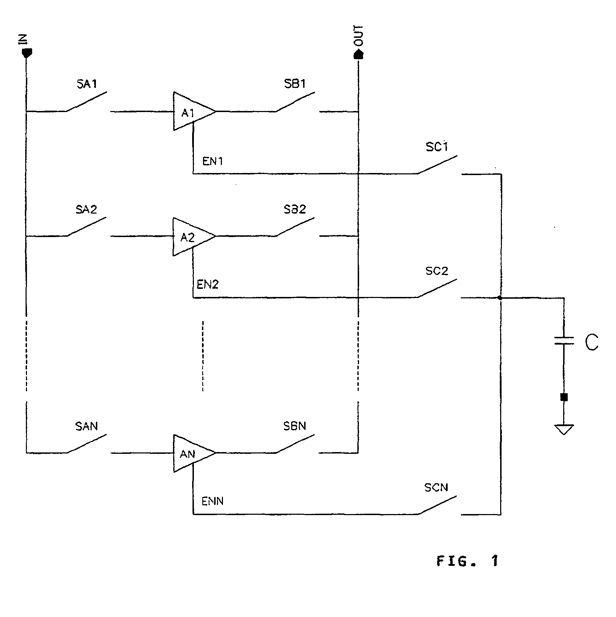

A general application of the present invention may be described by referring to Fig. 1. This figure shows N amplifiers (Ai), N triads of switches SAi, SBi, SCi, each associated to an amplifier Ai, and ultimately a capacitor (C). The switches act as selectors of one of the N amplifier and connect it to the capacitor C.

For example, the amplifier Ai is selected through the SAi, Sbi switches and the capacitor C is coupled to the selected amplifier Ai through the SCi switch. The scheme of Fig. 1 is applicable when the alternately operating N amplifiers demand large capacitors for their correct functioning. This may be needed to guarantee a high level of stability to the N feedback amplifiers and/or in case it is necessary to drastically reduce the pass band to reduce the noise power.

In these cases, the most immediate approach of using a capacitor for each amplifier would require a large silicon area for integrating all the capacitors or would require the use of N external capacitors and therefore N dedicated pins in case integrating the capacitor solution is too costly and/or unpracticable.

The scheme of Fig. 1 represents the known approach of employing a single capacitor to be selectively switched on the amplifier A1, A2, ... AN that are selected through the Sai and Sbi switches, by closing starting one of the SCi switches. The capacitor C may be integrated if convenient or alternatively may be an external capacitor requiring only one dedicated pin, thus the consequent remarkable reduction of costs.

The scheme of Fig. 1 may be realized by using, instead of the SAi and SBi switches, an alternative technique for selecting the amplifiers. Such technique consists in leaving in an ON state the selected amplifier and switching OFF all the deselected by controlling the bias current of the amplifiers.

This approach is preferable under many aspects and may also be used in the architecture of the present invention.

The circuit of Fig. 1 may be readily implemented in a CMOS technology thanks to the availability of analog switches of excellent performance realizable with MOS transistors. By contrast, in bipolar technology there may be several problems because of the use of analog switches realized with bipolar transistors operating between the cutoff and saturation regions.

A switch made with a bipolar junction transistor requires a relatively large base current in a switch-on phase and thus implies relatively long switching times. The main problem is in any case due to the fact that a bipolar junction transistor, when dynamically switched between the cutoff and the saturation regions, may trigger parasite transistors which may negatively affect the functioning of the integrated circuit.

OBJECT AND SUMMARY OF THE INVENTION

The main objective of the invention is that of providing a circuit implementation of the basic scheme of Fig. 1, effective even for a realization in bipolar technology.

The circuit of the invention effectively overcomes the problem of realizing the SCi switches, by avoiding to realize these switches with saturated bipolar junction transistors that are likely to induce spurious currents, upon switching on, which may originate undesired offset effects.

As far as the selection of one amplifier among the plurality of amplifiers is concerned, rather than using pairs of switches: SAi and SBi, the alternative technique of leaving in an ON state the selected amplifier and switch-off the others is employed.

Substantially, the circuit of the invention for coupling a capacitor on a supply node of an exclusively selected integrated amplifier belonging to a plurality of integrated amplifiers comprises:

- a first current generator connected between a first supply node (VCC) and a first node of the circuit;

- a second current generator connected between a second supply node (GND) and a second node of the circuit, electrically in parallel to the capacitor to be coupled to the selected amplifier;

- an array of switches identical in number to the integrated amplifiers, selectively and exclusively switcheable ON, each connecting a directly biased diode, between said two nodes of the circuit;

- each integrated amplifier having its own supply node coupled to the connection node between a respective diode and the connecting switch.

The invention is concisely defined in claim 1 and preferred embodiments are defined in the dependent claims.

BRIEF DESCRIPTION OF THE DRAWINGS

Figure 1 depicts the scheme of selection of an amplifier and of the switching of the only capacitor C on the supply node of the selected amplifier;

Figure 2 is a basic scheme of the circuit of the invention;

Figure 3 shows the circuit of the selection blocks of one of several integrated amplifiers of the invention;

Figure 4 shows a preferred embodiment of the circuit of the invention.

DESCRIPTION OF AN EMBODIMENT OF THE CIRCUIT OF THE INVENTION

A practical application of the circuit of the invention to error amplifiers with a resistive load, used for controlling the amplitude of the oscillations in a voltage mode LC oscillator (VCO) for radio frequency integrated circuits, is described purely for illustration purposes. These oscillators use a variable capacitor in the resonating LC network, which is implemented in the form of an inversely biased PN junction diode. These diodes (typically a standard base-emitter or base-collector junction), due to the relatively low voltage of operation, exhibit a junction capacity having a small "spread", which limits the regulation range of the VCO frequency.

A solution to the problem of covering a frequency range sufficiently ample for radio frequency applications, is that of employing several oscillators, and therefore several error amplifiers, that are selectable according to needs.

Notably, the error amplifier contributes heavily to the phase noise of the VCO, especially when the latter operates with large amplitude of oscillation. Indeed, the nonlinear behavior of the VCO modulates the low frequency noise of the error amplifier and shifts it to high frequencies, superimposing it to the intrinsic noise produced by the oscillator itself.

To reduce the low noise frequency component of the error amplifier it is necessary to employ large filtering capacitors.

Because it is also necessary to ensure a low phase noise, typically within a few tens of Kilohertz, filtering capacitors of large capacitance, usually to be connected externally to the integrated circuit are required. Therefore, the problem is to find a circuit implementing the basic scheme of Fig. 1, which though satisfying the filtering specifications with a unique capacitor and through only one dedicated pin, does not trigger parasite transistors and/or cause offset phenomena.

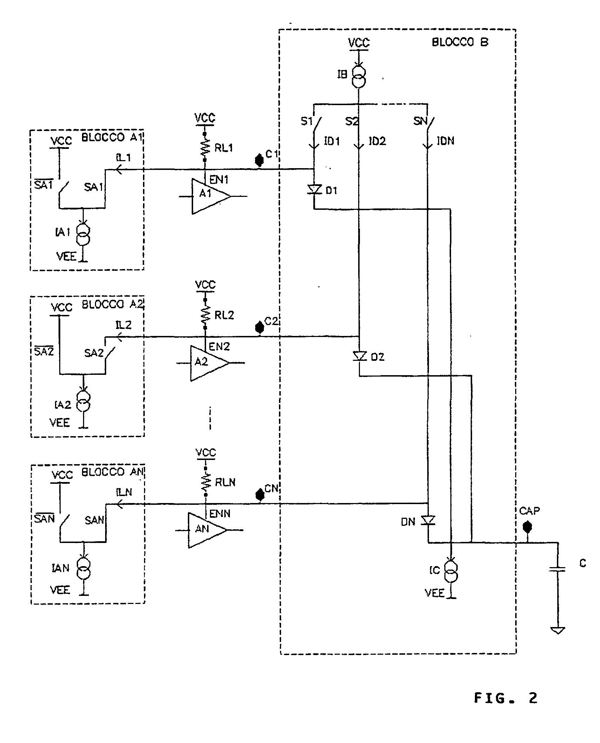

By referring to the scheme of the invention shown in Fig. 2, the capacitor C is effectively switched on the different amplifiers: A1, A2, ... AN, as described above. The elements A1-AN indicate the N error amplifiers on a supply node of which capacitor C must be switched, the RL1-RLN resistors representing respective load elements.

The parts indicated as the block A1-AN represent the on/off selector switches which effect the selection of the amplifiers. Another array of switches, not shown in Fig. 2, operate synchronously with the SAi switches to switch off simultaneously the operating current on the deselected amplifiers.

In the above described scheme, the switching circuit of the capacitor C of the present invention is represented by the block B.

The block B must connect the capacitor C to one of the N amplifiers in a most efficient manner.

The circuit selectively activates one of the N diodes D1, D2, ..., DN, bringing it to a condition of direct bias, thus creating a low impedance connection path between the selected amplifier and the capacitor.

The selection of one of the N diodes may be performed through a decoder establishing in the selected diode an adequate biasing current (IB) forced by the relative current generators IB and IC.

To avoid an undesired offset in the selected amplifier, due to a difference between the IB and IC currents, which would reflect itself on the RLi load, a current gain (b) compensating circuit of the PNP transistors (if we consider a bipolar embodiment) is introduced, which parameter (b) is the main cause of any offset problem. Thanks to such circuit which is disclosed in details in the ensuing description, the currents IB and IC are equalized with a high precision.

The switch Si of the capacitor C of Fig. 2 is closed simultaneously with the opening of the selection switch Sai of the integrated amplifier, while all the other switches SAj (j≠i) are closed setting to an OFF state all the deselected amplifiers.

The closing switching ON of Si switches the IB current through the respective diode Di while the other diodes are left in an OFF state.

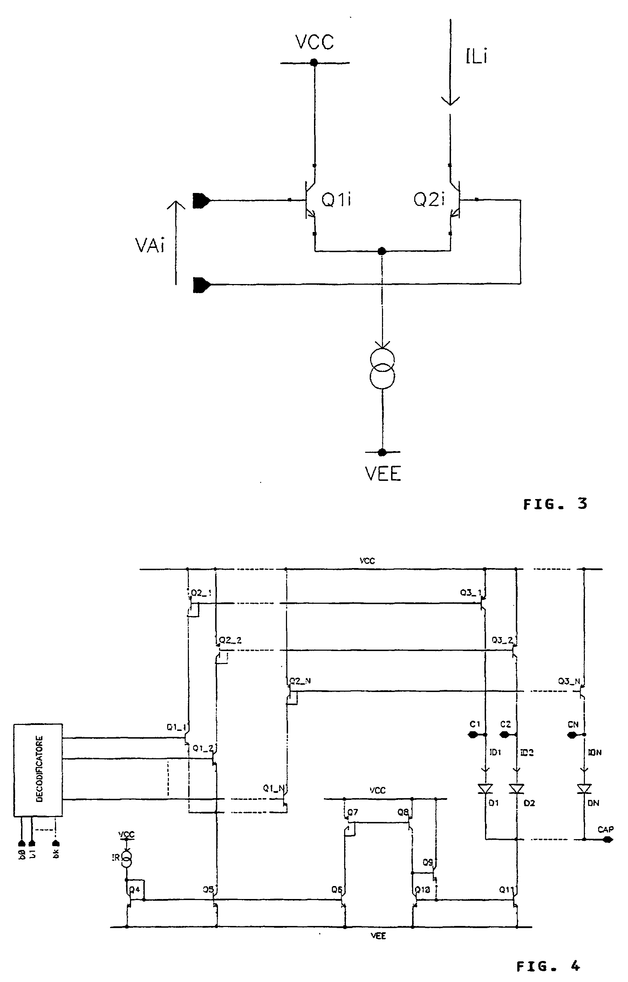

The circuits that implement the Ai block and the B block are shown respectively in Figures 3 and 4.

The circuit of Fig. 3 is a common current selector based on a differential pair of transistors.

In the circuit of Fig. 4, the decoder and the transistors Q1_1-Q1_N realize the switches S1-SN and the relative control, while the current generator IR, the mirror Q4-Q5 and the mirrors formed by the transistors Q2_1-Q2_N and Q3_1-Q3_N, realize the generator IB. The generator IC is realized by the current generator IR and the mirrors Q4-Q6, Q7-Q8 and Q10-Q11.

The functioning of the circuit is as follows.

A program word, formed by the bo-bk bits, switches the current of Q5 on one of the N transistors Q1_i acting as switches. Such a current, through the PNP transistors mirrors Q2_i and Q3_i is forced on the selected diode Di.

To make the current of Q3_i equal to that of Q11 (that is of IC) thereby preventing offset problems as previously mentioned, the current IR, instead of being directly mirrored on Q11, is firstly passed through a PNP current mirror, Q7-Q8 and successively mirrored on Q11 by Q9-Q10. In this way the currents of Q11 and of Q3_i will be equal apart from tolerance errors.

The fact that the capacitance is linked through the dynamic resistance of a directly biased diode involves a slight change in the desired "dominant pole" model. Indeed, what happens is the presence of a "zero" associated to the incremental resistance, rd of the directly biased diode.

The resulting expressions of the dominant pole and of the zero respectively are:

$$ f_p = \frac{1}{2\pi * RLi * C} \qquad f_z = \frac{1}{2\pi * rd * C} $$

From these equations it may be observed that the IB current, and thus the IC current, should not be fixed to a value too low, because this would imply a "zero" too close to the pole. Currents of about 50 μA are in most cases sufficient to guarantee an adequate separation between the pole and the zero.

## Claims

1. A circuit for coupling in an exclusive manner a capacitor (C) connected to a ground node of the circuit to a supply node of a selected one of a plurality of integrated amplifiers (A1, A2, ... AN), **characterized in that** it comprises:

   a first current generator (IB) connected between a first supply node (VCC) and a first node of the circuit (H);

   a second current generator (IC)-connected between a ground node (GND) and a second node (L) of the circuit, electrically in parallel to said capacitor (C);

   an array of switches (S1 ...SN) of the same number as said plurality of integrated amplifiers, said switches are connected to said amplifiers so that only one amplifier of said plurality of amplifiers is switched on at any time; and

   a plurality of diodes (D1...DN) of the same number as said plurality of integrated amplifiers, each switch connecting a respective one of said diodes between said first node and said second node, wherein said respective diode is directly biased;

   each integrated amplifier having a supply node coupled to the connecting node between a respective one of said diode, and a respective one of said connecting switches of said array.

2. The circuit according to claim 1, **characterized in that** the selection of one of the switches (S1, S2, ..., SN) of said array is effected by a program word composed of k+1 bits applied to the input of a k+1 decoding register which controls a plurality of transistors (Q1_1 ... Q1_N), each transistor (Q1_i) of said plurality of transistors (Q1_1 ... Q1_N) constitutes one switch of said array of switches;

   said first generator and said second generator (IC) being implemented by a unique current generator (IR) and a plurality of current mirrors (Q4 - Q5, Q2_1 - Q3_1, Q2_N - Q3_N, Q4-Q6, Q7-Q8, Q10-11).

3. The circuit according to claim 2, **characterized in that** the current generated by said first and second current generator (IB, IC) is at least equal or higher than 50 μA.

## Patentansprüche

1. Schaltung zur Kopplung eines Kondensators in einer exklusiven Weise, der mit einem Masseknoten der Schaltung verbunden ist, an einen Versorgungsknoten eines ausgewählten von mehreren integrierten Verstärkern (A1, A2, ... AN), **dadurch gekennzeichnet, daß** er aufweist:

   einen ersten Stromerzeuger (IB), der zwischen einem ersten Versorgungsknoten (VCC) und einem ersten Knoten der Schaltung (H) geschaltet ist;
   einen zweiten Stromerzeuger (IC), der zwischen einem Masseknoten (GND) und einem zweiten Knoten (L) der Schaltung elektrisch parallel zu dem Kondensator (C) geschaltet ist;
   eine Anordnung von Schaltern (S1 ...SN) derselben Anzahl wie die Anzahl der mehreren integrierten Verstärker, wobei die Schalter so mit den Verstärkern verbunden sind, daß nur ein Verstärker der mehreren Verstärker zu irgendeiner Zeit eingeschaltet ist; und
   mehrere Dioden (D1 ... DN) derselben Anzahl wie die Anzahl der mehreren integrierten Verstärker, wobei jeder Schalter eine jeweilige der Dioden zwischen dem ersten Knoten und dem zweiten Knoten schaltet, wobei die jeweilige Diode direkt vorgespannt ist;

wobei jeder integrierte Verstärker einen Versorgungsknoten aufweist, der mit dem Verbindungsknoten zwischen einer jeweiligen der Dioden und einem jeweiligen der Verbindungsschalter der Anordnung gekoppelt ist.

**2.** Schaltung nach Anspruch 1, **dadurch gekennzeichnet, daß** die Auswahl eines der Schalter (S1, S2, ..., SN) der Anordnung durch ein Programmwort bewirkt wird, das aus k+1 Bits besteht, das an den Eingang eines k+1-Decodierregisters angelegt wird, das mehrere Transistoren (Q1_1 .... Q1_N) steuert, wobei jeder Transistor (Q1_i) der mehreren Transistoren (Q1_1 ... Q1_N) einen Schalter der Anordnung von Schaltern bildet; der erste Erzeuger und der zweite Erzeuger (IC) durch einen einzigen Stromerzeuger (IR) und mehrere Stromspiegel (Q4-Q5, Q2_1-Q3_1, Q2_N-Q3_N, Q4-Q6, Q7-Q8, Q10-Q11) implementiert ist.

**3.** Schaltung nach Anspruch 2, **dadurch gekennzeichnet, daß** der Strom, der durch den ersten und zweiten Stromerzeuger (IB, IC) erzeugt wird, mindestens gleich oder höher als 50 µA ist.

**Revendications**

**1.** Circuit pour coupler de façon exclusive un condensateur (C) connecté à un noeud de masse du circuit à un noeud d'alimentation de l'un sélectionné d'une pluralité d'amplificateurs intégrés (A1, A2 ... AN), **caractérisé en ce qu'**il comprend :

    un premier générateur de courant (IB) connecté entre un premier noeud d'alimentation (VCC) et un premier noeud du circuit (H) ; un second générateur de courant (IC) connecté entre un noeud de masse (GND) et un second noeud (L) du circuit, électriquement en parallèle sur le condensateur (C) ; un réseau de commutateurs (S1 ... SN) en nombre égal au nombre de la pluralité d'amplificateurs intégrés, les commutateurs étant connectés aux amplificateurs de sorte qu'un seul amplificateur de la pluralité d'amplificateurs est commuté à tout instant donné ; et une pluralité de diodes (D1 ... DN) en nombre égal au nombre de la pluralité d'amplificateurs intégrés, chaque commutateur connectant l'une respective des diodes entre le premier noeud et le second noeud, dans lequel la diode respective est polarisée en direct ; chaque amplificateur intégré ayant un noeud d'alimentation couplé au noeud de connexion entre l'une respective des diodes et l'un respectif des commutateurs de connexion du réseau.

**2.** Circuit selon la revendication 1, **caractérisé en ce que** la sélection de l'un des commutateurs (S1, S2 ... SN) du réseau est réalisée par un mot de programme constitué de k+1 bits appliqués à l'entrée d'un registre de décodage parmi k+1 qui commande une pluralité de transistors (Q1_1 ... Q1_N), chaque transistor (Q1_i) de la pluralité de transistors (Q1_1 ... Q1_N) constituant un commutateur du réseau de commutateurs ;

    le premier générateur et le second générateur (IC) étant mis en oeuvre par un générateur de courant unique (IR) et une pluralité de miroirs de courant (Q4-Q5, Q2_1-Q3_1, Q2_N-Q3_N, Q4-Q6, Q7-Q8, Q10-Q11).

**3.** Circuit selon la revendication 2, **caractérisé en ce que** le courant produit par les premier et second générateurs de courant (IB, IC) est au moins égal ou supérieur à 50 µA.

FIG. 1

FIG. 2

FIG. 3

FIG. 4